# EUROPEAN PATENT SPECIFICATION

(11) **EP 0 670 103 B1**
(45) Date of publication and mention of the grant of the patent: **02.09.1998**
(21) Application number: 94927849.3
(22) Date of filing: 22.09.1994
(51) Int. Cl.: H05K 3/30, C09J 5/00

(54) **LOCAL HARDENING METHOD OF AN ADHESIVE FOR A SEMICONDUCTOR INTEGRATED CIRCUIT**
VERFAHREN ZUR LOKALEN HÄRTUNG EINES KLEBSTOFFES FÜR EINE INTEGRIERTE HALBLEITERSCHALTUNG
PROCEDE DE DURCISSEMENT LOCAL D'UN ADHESIF POUR UN CIRCUIT INTEGRE A SEMI-CONDUCTEURS

(30) Priority: 22.09.1993 KR 1926493
(43) Date of publication of application: 06.09.1995
(73) Proprietor: SAMSUNG ELECTRONICS CO., LTD., Suwon-City, Kyounggi-Do 441-370 (KR)
(72) Inventor: KIM, Soung-ju Samsung Electronics Co., Ltd., Paldal-gu Suwon City Kyungki-do 441-370 (KR)
(74) Representative: Neill, Alastair William
(86) International application number: KR9400127
(87) International publication number: WO9509521

(56) References cited:
- EP-A- 16 984
- EP-A- 218 832
- EP-A- 330 909
- EP-A- 378 233

## Description

This invention relates to a local mounting and hardening method of a semiconductor, for a example to mount and harden a Quad Flat Package integrated circuit locally by using a hole formed in PCB (Printed Circuit Board). More particularly it relates to a method of mounting a semiconductor integrated circuit in which a conventional manual soldering method is converted to an automatic soldering method by making local mount of a semiconductor integrated circuit on a PCB assembly frame possible.

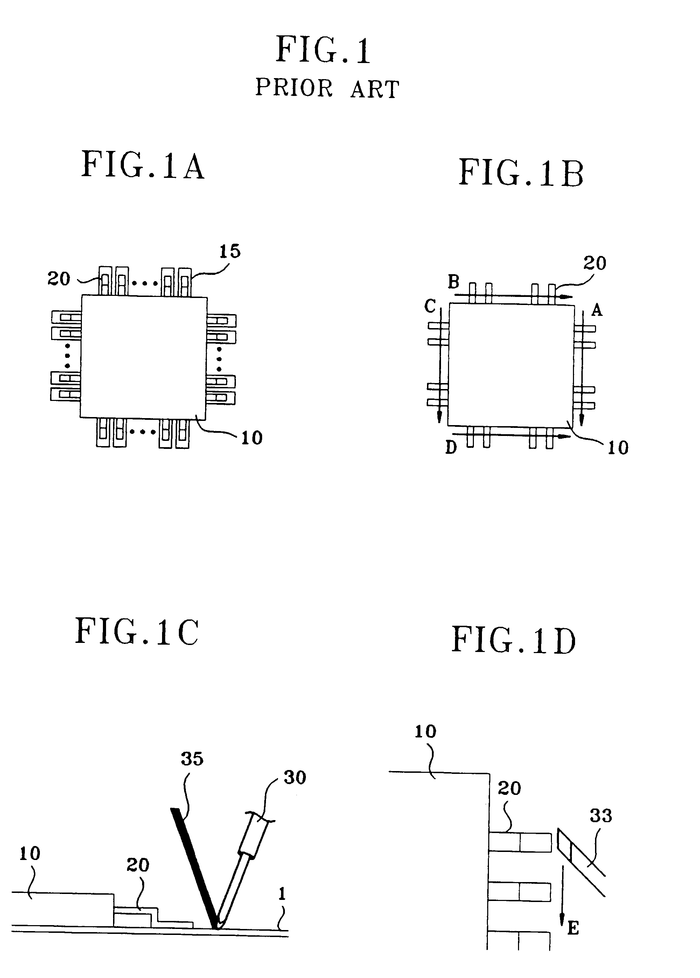

According to a conventional method, as shown in Figure 1A to Figure 1D, in SMT (System Multi Tester) mounting process, an mounting-impossible point of an integrated circuit 10 is manually put on PCB, a lead and PCT solder land 15 are united and fixed by pressing the integrated circuit by hands, and every lead 20 is manually soldered in every direction by a soldering iron.

The conventional soldering method is described more concretely with reference to Figures 1A-1D.

As shown in Figure 1A a semiconductor integrated circuit is attached on a PCB wafer after fitting it in its mounting direction, and the locations of a lead 20 and a solder land 15 are manually adjusted and set up. As shown in Figure 1B, the upper circuit 10 is lightly pressed and held by left fingers. The lead 20 of the circuit 10 is coated with flux with a brush. Generally, said flux is coated in the directions of A side and B side (lengthwise and widthwise). When said process is finished, as shown in Figure 1C, an iron 30 covered with a small amount of solder via solder bar 35 moves following the arrow and solder the part A of Figure 1B. It also moves to parts B, C, and D to solder them in the same method.

When the solder is finished, cooling and contact of the solder are inspected by a microscope 33. If contacted, the soldering iron 30 is moved to the lead 20 direction, as it were, to the outside direction (E direction of Figure 1D) and removed.

The above-mentioned conventional manual mounting and soldering method has disadvantages to need much time and a worker's long time attention in order to prevent mounting twist to be generated by the reason that the semiconductor integrated circuit fails to land precisely on the PCB in the range of 0.3 mm to 0.4 mm. Cooling solder and soldering short phenomenon is also much generated, the long time for inspection is required, and degradation of the quality is happened.

EP 0016984 describes a method of mounting electronic components on a PCB by temporarily attaching the component to the board with adhesive applied to the board. The adhesive is cured by irradiation with ultraviolet rays from above the aboard such that excess adhesive portions adjoining the side edge of the component are cured first to subsequently cure the portion of adhesive between the component and the board in chain relation to the curing of the excess.

This invention has purposes to prevent mounting twist, cooling solder, soldering short, and coming off of a semiconductor integrated circuit and to provide a method of mounting a semiconductor integrated circuit which makes automatic soldering possible and improves quality and reliability of goods by making a 0.8 mm x 3.0 mm's cross-shaped hole on a PCB for safely attaching a semiconductor integrated circuit thereto, coating the hole with bonding material automatically, mounting the semiconductor integrated circuit by coordinates automatically, and hardening locally by ultraviolet rays through the crossshaped hole.

To achieve said purposes, a method of mounting a semiconductor integrated circuit of this invention has characteristics to be comprised of the steps of forming a hardening hole on a printed circuit board (PCB) for auto-inserting a semiconductor integrated circuit, detecting whether any defect exists in the auto-inserted parts of PCB box in APTs (Auto Program Testers), reversing the PCB in a PCB reverser so as to show an upper copper-clad side of the PCB, applying bonding material to a designated hole point of the reversed PCB in a local bonding machine, mounting precisely the semiconductor integrated circuit on a designated point by coordinates in a semiconductor local mounting machine, attaching and fixing a semiconductor integrated circuit on the copper-clad side of the PCB by passing ultraviolet rays through the hardening hole in an ultraviolet hardening machine, controlling soldering by an auto-soldering machine after said semiconductor integrated circuit is attached.

Figure 1A to Figure 1D are schematic diagrams to show mounting and soldering process of a conventional semiconductor integrated circuit.

Figure 2A and Figure 2B are diagrams to show hardening holes of a semiconductor integrated circuit according to this invention.

Figure 3 to Figure 3C are schematical diagrams to show a method of mounting a semiconductor integrated circuit according to this invention.

A preferred embodiment of a method of mounting a semiconductor integrated circuit in accordance with this invention is explained in detail with appended diagrams hereinafter.

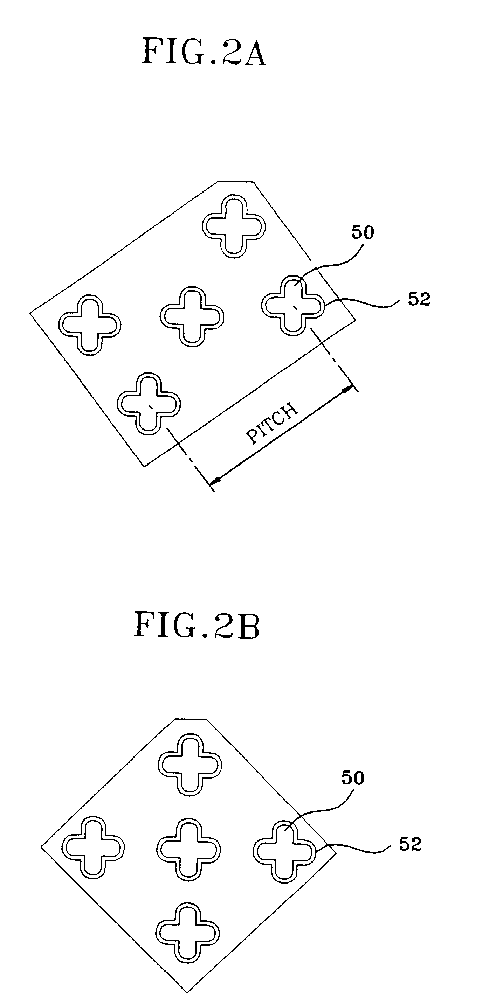

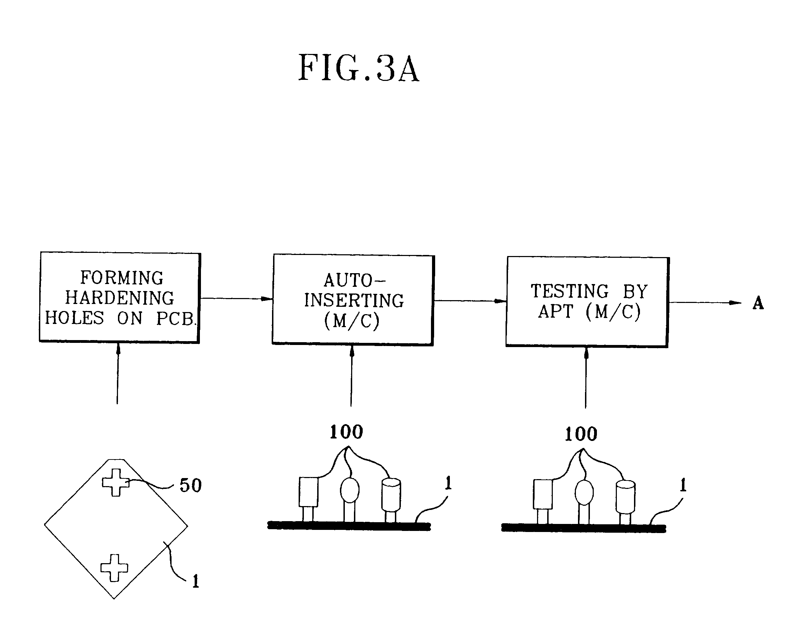

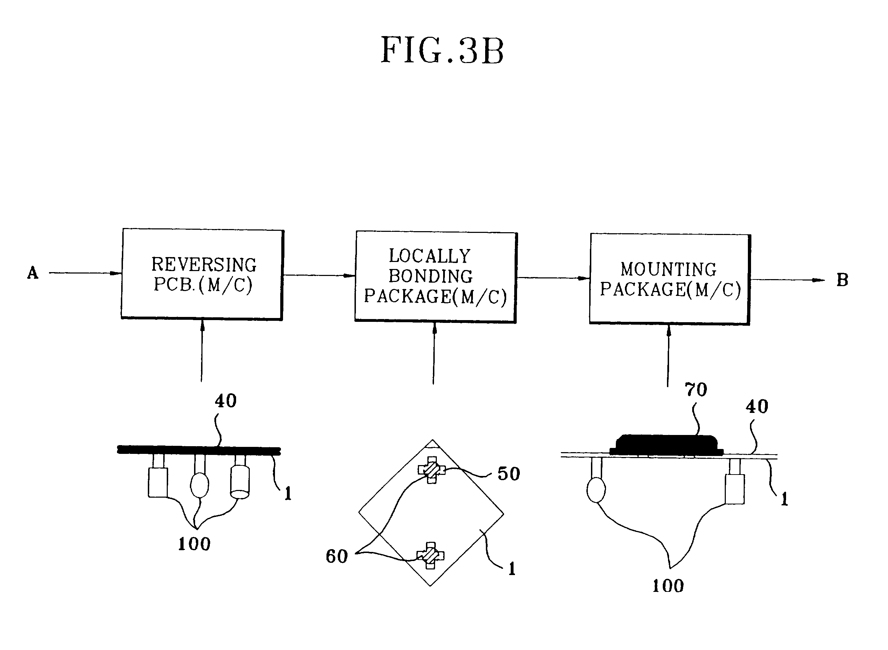

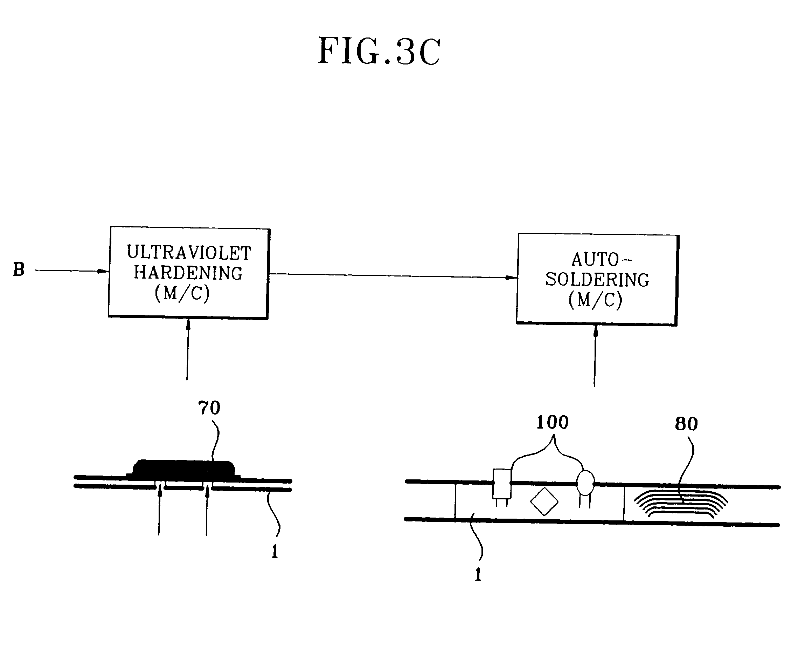

Figure 3A to Figure 3C are block diagrams to briefly show a method of mounting a semiconductor integrated circuit according to this invention. First of all, a hardening hole 50 in the shape of "+", as shown in Figure 2A and Figure 2B, is formed on a PCB, and auto-insertion of a semiconductor integrated circuit is carried out. Though the cross shape ("+") is desirable for the hardening hole, such polygonal shapes like a circle, square, and triangle are also possible if necessary. The number of hardening holes is at least one. Though five hardening holes in the shape of "+" may be set up in the various directions in Figure 2A and Figure 2B, it is desirable to set them up in mainly diagonal direction. Preferably interval of the hole shown in Figure 2A is to be under 20 mm and hole size is 0.7 mm x 1.5 mm to 1.0 mm x 5.0mm.

After detecting any existence of defect in the auto-inserted parts of auto-inserted PCB box in the APT (Auto Program Tester), if any defect is not exist, the PCB wafer 1 is reverted by the PCB reverser to show a copper-clad side, the upper side thereof. Reference symbol M/C indicates a machine in the drawings and reference symbol 100 represents each necessary part.

The points 60 of designated hardening hole of the reversed PCB wafer 1 are coated with bonding material in a semiconductor local bonding machine. After coating the bonding materials in the hardening holes, the areas 52 surrounding the bonding areas are cleaned to enable the semiconductor IC chip 70 to be able to be firmly attached to the PCB by means of the bonding materials of the hardening holes.

In a semiconductor local mounting machine, mounting is performed by coordinates to precisely mount a semiconductor integrated circuit on the designated point. After the semiconductor integrated circuit is mounted, ultraviolet rays are passed to the arrow direction through the hardening hole 50 in the ultraviolet-ray hardening machine and a semiconductor integrated circuit 70 is attached and fixed on the copper-clad side 40 of the PCB, and then soldering shape is regulated by the auto soldering machine and finished. Unexplained reference symbol 80 is soldering bath.

According to the invention, the semiconductor can be attached to the PCB by less workers, reducing the degradation in the quality and achieving the improvement of the productivity by clearing up mounting twist, cooling solder, soldering short, and coming off phenomena of the attached semiconductor integrated circuit and making auto-mounting and auto-soldering of the semiconductor integrated circuit possible.

While the present invention has been particularly shown and described with reference to a particular embodiment thereof, it will be understood by those skilled in the art that various changes in form and details may be effected therein without departing from the scope of the invention as defined by the appended claims.

## Claims

1. A method of mounting a semiconductor integrated circuit (70), comprising the steps of
forming a hardening hole (50) on a printed circuit board (1) for auto-inserting a semiconductor integrated circuit (70);
detecting whether any defect exists in the auto-inserted parts of PCB box in APTs;
reversing said PCB in a PCB reverser so as to show an upper copper-clad side (40) of the PCB;
applying bonding material to a designated hole point (60) of the reversed PCB in a local bonding machine;
mounting precisely the semiconductor integrated circuit on a designated point by coordinates in a semiconductor local mounting machine;
attaching and fixing a semiconductor integrated circuit on the copper-clad side of the PCB by passing ultraviolet rays through the hardening hole in an ultraviolet hardening machine; and
controlling soldering by an auto-soldering machine after said semiconductor integrated circuit is attached.

2. The method according to claim 1, wherein said hardening hole is formed in the shape of a circle.

3. The method according to claim 1, wherein said hardening hole is formed in the shape of a triangle.

4. The method according to claim 1, wherein said hardening hole is formed in the shape of a square.

5. The method according to claim 1, wherein said hardening hole is formed in the shape of a polygon.

6. The method according to any preceding claim, wherein said hardening hole number is one.

7. The method according to any of claims 1 to 5, wherein said hardening hole number is two to five,.

8. The method according to any preceding claim, wherein said hardening holes are formed with a pitch of less than 20 mm.

9. The method according to any preceding claim, wherein after applying the bonding material to the hardening holes (50), the areas (52) surrounding the bonding areas are cleaned to enable the semiconductor integrated circuit (70) to be firmly attached to the PCB (1) by means of the bonding material of the hardening holes.

10. The method according to any preceding claim, wherein said hardening holes are formed in the size of 0.7 mm x 1.5 mm to 1.0 mm x 5.0 mm.

## Patentansprüche

1. Verfahren zum Montieren einer integrierten Halbleiterschaltung (70), das die folgenden Schritte umfaßt:
Herstellen eines Aushärtlochs (50) auf einer Leiterplatte (1) zum Selbsteinführen einer integrierten Halbleiterschaltung (70);
Erfassen, ob ein Defekt der automatisch eingeführten Teile des Leiterplattenkastens (PCB-Box) vorliegt, in Auto-Programmtestern (APT);
Umdrehen der Leiterplatte in einer Leiterplatten-Umdreheinrichtung, um eine obere kupferkaschierte Seite (40) der Leiterplatte zu zeigen;
Auftragen von Klebstoffmaterial auf einen vorgegebenen Lochpunkt (60) der umgedrehten Leiterplatte in einer Lokal-Klebeeinrichtung;
genaues Montieren der integrierten Halbleiterschaltung an einem durch Koordinaten bezeichneten Punkt in einer Halbleiter-Lokal-Montageeinrichtung;
Anbringen und Befestigen einer integrierten Halbleiterschaltung auf der kupferkaschierten Seite der Leiterplatte durch das Hindurchleiten von ultravioletten Strahlen durch das Aushärtloch in einer Ultraviolett-Aushärteinrichtung; und
Steuern des Lötens durch eine Auto-Löteinrichtung nach dem Anbringen der integrierten Halbleiterschaltung.

2. Verfahren nach Anspruch 1, wobei das Aushärtloch die Form eines Kreises hat.

3. Verfahren nach Anspruch 1, wobei das Aushärtloch die Form eines Dreiecks hat.

4. Verfahren nach Anspruch 1, wobei das Aushärtloch die Form eines Quadrates hat.

5. Verfahren nach Anspruch 1, wobei das Aushärtloch die Form eines Vielecks hat.

6. Verfahren nach einem der vorangehenden Ansprüche, wobei die Anzahl der Aushärtlöcher 1 beträgt.

7. Verfahren nach einem der Ansprüche 1 bis 5, wobei die Anzahl der Aushärtlöcher 2 bis 5 beträgt.

8. Verfahren nach einem der vorangehenden Ansprüche, wobei die Aushärtlöcher mit einem Abstand von weniger als 20 mm ausgebildet sind.

9. Verfahren nach einem der vorangehenden Ansprüche, wobei nach dem Auftragen des Klebstoffmaterials auf die Aushärtlöcher (50) die Bereiche (52), die die Klebebereiche umgeben, gereinigt werden, um die integrierte Halbleiterschaltung (70) mit dem Klebstoffmaterial der Aushärtlöcher fest an der Leiterplatte (1) anbringen zu können.

10. Verfahren nach einem der vorangehenden Ansprüche, wobei die Aushärtlöcher in der Größe von 0,7 mm x 1,5 mm bis 1,0 mm x 5,0 mm ausgebildet sind.

## Revendications

1. Procédé de montage d'un circuit intégré à semi-conducteur (70), comprenant les étapes de
formation d'un trou à durcissement (50) sur une carte à circuit imprimé (PCB) (1) pour l'insertion automatique d'un circuit intégré à semi-conducteur (70) ;
détection d'un défaut éventuel dans les éléments à insertion automatique de boîtier PCB, dans des contrôleurs à programmation automatique (APT) ;
renversement de ladite PCB dans un retourneur de PCB de manière à exposer un côté supérieur plaqué cuivre (40) de la PCB ;
application d'un matériau de fixation sur un point désigné formant trou (60) de la PCB retournée, dans une machine de fixation locale ;
montage précis du circuit intégré à semi-conducteur sur un point désigné par des coordonnées dans une machine de montage local de composants à semi-conducteur ;
fixation et immobilisation d'un circuit intégré à semi-conducteur sur le côté plaqué cuivre de la PCB en faisant passer des rayons ultraviolets dans le trou à durcissement, dans une machine de durcissement par rayonnement ultraviolet ; et
commande du brasage par une machine de brasage automatique, après que ledit circuit intégré à semi-conducteur a été fixé.

2. Procédé selon la revendication 1, dans lequel ledit trou à durcissement se présente sous la forme d'un cercle.

3. Procédé selon la revendication 1, dans lequel ledit trou à durcissement se présente sous la forme d'un triangle.

4. Procédé selon la revendication 1, dans lequel ledit trou à durcissement se présente sous la forme d'un carré.

5. Procédé selon la revendication 1, dans lequel ledit trou à durcissement se présente sous la forme d'un polygone.

6. Procédé selon l'une quelconque des revendications précédentes, dans lequel il y a un seul trou à durcissement.

7. Procédé selon l'une quelconque des revendications 1 à 5, dans lequel le nombre de trous à durcissement est compris entre deux et cinq.

8. Procédé selon l'une quelconque des revendications précédentes, dans lequel lesdits trous à durcissement sont formés avec un pas inférieur à 20 mm.

9. Procédé selon l'une quelconque des revendications précédentes, dans lequel, après l'application du matériau de fixation sur les trous à durcissement (50), les zones (52) entourant les zones de liaison sont nettoyées pour permettre la fixation solide du circuit intégré à semi-conducteur (70) sur la PCB (1) au moyen du matériau de fixation des trous à durcissement.

10. Procédé selon l'une quelconque des revendications précédentes, dans lequel la taille desdits trous à durcissement est comprise dans la fourchette de 0,7 mm x 1,5 mm à 1,0 mm x 5,0 mm.
